# EUROPÄISCHE PATENTANMELDUNG

(11) **EP 1 970 966 A2**
(43) Veröffentlichungstag der Anmeldung: **17.09.2008**
(21) Anmeldenummer: 08003167.7
(22) Anmeldetag: 21.02.2008
(51) Int. Cl.: H01L 31/042, H01L 31/05

(54) **Elektrisches Verbindungselement für Solarzellen**

(30) Priorität: 12.03.2007 DE 102007012234
(71) Anmelder: Webasto AG, 82131 Stockdorf (DE)
(72) Erfinder: Pätz, Werner, 86928 Hofstetten (DE); Vilsmayer, Sven, 86932 Pürgen-Lengenfeld (DE); Kloger, Rupert, 82166 Gräfelfing (DE); Teschner, Helmut, 86899 Landsberg (DE); Erbeck, Gerit, 85467 Neuching (DE); Brandner, Hans, 85521 Dachau (DE); Ludwig, Thomas, 82327 Tutzing (DE)

(57) **Zusammenfassung**

Die Erfindung betrifft elektrisches Verbindungselement (4), insbesondere zum elektrischen Verbinden zweier Solarmodule (1), mit einer Trägereinrichtung (5), mindestens einer Halterung (6), die an der Trägereinrichtung (5) angeordnet ist, und mindestens einem Kontaktelement (7), das durch eine der Halterungen (6), beweglich zu der Trägereinrichtung (5) angeordnet ist.

## Beschreibung

Die vorliegende Erfindung betrifft ein elektrisches Verbindungselement, insbesondere ein elektrisches Verbindungselement zum elektrischen Verbinden zweier Solarzellenmodule oder Solargeneratoren.

Solarzellenmodule, auch als Solargeneratoren bezeichnet, werden zum Gewinnen von elektrischer Energie durch Umwandeln der Sonneneinstrahlung auf Hausdächern, Fassaden oder Freiflächen verwendet. Die vorgefertigten Solarzellenmodule beinhalten mehrere Solarzellen, ein oder mehrere externe Anschlüsse und einen mechanisch stabilisierenden Rahmen oder ein stabilisierendes Gehäuse.

Gängige Solarzellenmodule weisen als externe Anschlüsse Kabel auf, die ein Zusammenschließen von mehreren Solarzellenmodulen zu größeren Einheiten auf einem Dach ermöglichen. Damit die einzelnen Solarzellenmodule zueinander frei auf dem Dach angeordnet werden können, ist die Länge der Kabel der vorgefertigten Solarzellenmodule entsprechend der längsten Verbindungsstrecken ausgelegt. Der ohmsche Widerstand der Kabel verringert die Systemperformance der verbundenen Solarzellenmodule. Zudem können die Kabel durch Witterung, mechanische Einflüsse und Marderverbiss beschädigt werden.

Aus der JP 9-135039 ist eine elektrische Steckverbindung zum elektrischen Verbinden von zwei Solarzellenmodulen bekannt. Die elektrische Steckverbindung weist eine Halterung auf, die an einem Dach befestigt wird. An zwei gegenüberliegenden Seiten der Halterung sind zwei Stecker befestigt. Die beiden Stecker sind über ein Kabel elektrisch miteinander verbunden. An den Solarzellenmodulen sind an einer Unterseite Buchsen vorgesehen, in die die Stecker beim Aufsetzen der Solarzellenmodule auf die elektrischen Stecker eingreifen.

Die Solarzellenmodule müssen präzise eingepasst werden, damit ein Kontaktschluss der einzelnen Steckverbindungen, typischerweise an den Ecken des Solarzellenmoduls, gewährleistet ist. Bei den großflächigen Solarzellenmodulen von mehr als einem Quadratmeter Fläche erfordert dies einen erheblichen Montageaufwand.

Es ist eine Aufgabe der vorliegenden Erfindung ein elektrisches Verbindungselement bereitzustellen, das eine vereinfachte Montage von Solarzellenmodulen ermöglicht.

Die oben stehende Aufgabe wird durch das elektrische Verbindungselement mit den Merkmalen des Patentanspruchs 1 gelöst.

Das elektrische Verbindungselement sieht vor:
eine Trägereinrichtung,
mindestens eine Halterung, die an der Trägereinrichtung angeordnet ist, und
mindestens ein Kontaktelement, das durch eine der Halterungen beweglich zu der Trägereinrichtung angeordnet ist.

Die Idee der vorliegenden Erfindung besteht darin, die Kontaktelemente nicht starr bezüglich der Trägereinrichtung zu befestigen, sondern mit einem Spiel, insbesondere in der Ebene parallel zu den Solarzellenmodulen, zu versehen.

Ausgestaltungen und Weiterbildung der vorliegenden Erfindung sind in den Unteransprüchen und den Ausführungsformen angegeben.

In einer Ausgestaltung ist vorgesehen, dass eine flexible elektrische Verbindung ein' erstes der Kontaktelemente mit einem zweiten der Kontaktelemente verbindet. Die flexible elektrische Verbindung gewährleistet, dass die Kontaktelemente relativ zueinander verschiebbar sind und gleichzeitig eine elektrische Verbindung sichergestellt ist.

Gemäß einer Weiterbildung ist die flexible elektrische Verbindung durch ein elektrisch leitendes Federelement gebildet. Das elektrisch leitende Federelement stellt die Kontaktelemente in ihre Ausgangsposition zurück bzw. hält die Kontaktelemente in einer Ausgangsposition, sodass ein mehrmaliges Aufsetzen von Solarzellenmodulen ermöglicht wird.

Die Halterung kann mindestens ein Federelement zum Rückstellen einer der mindestens einen Halterung aufweisen.

Eine Ausgestaltung sieht vor, dass die mindestens eine Halterung als durchgehendes Loch (Langloch) in der Trägereinrichtung ausgebildet ist und das mindestens ein Kontaktelement in das durchgehende Loch eingesteckt ist.

In einer weiteren Ausgestaltung ist in der Ebene des durchgehenden Lochs in zumindest einer Richtung das Kontaktelement von der Trägereinrichtung durch einen Spalt beabstandet. Der Spalt oder Freiraum ermöglicht eine seitliche Bewegung des durch das Loch gesteckten Kontaktelementes.

Nach einer Weiterbildung weist ein Bereich des mindestens einen Kontaktelements, der innerhalb des durchgehenden Lochs angeordnet ist, einen durch eine Einschnürung verringerten Querschnitt gegenüber benachbarten Bereichen des Kontaktelementes auf. Der in dem Bereich der Einschnürung verringerte Querschnitt ermöglicht dem Kontaktelement eine seitliche Bewegung, während zugleich das Kontaktelement durch die breiteren Bereiche neben der Einschnürung mechanisch an dem Loch gesichert ist.

Gemäß einer Weiterbildung ist das mindestens eine Kontaktelement in Polyurethan-Schaum eingebettet. Der Spalt kann durch Polyurethan-Schaum ausgefüllt sein.

Eine Weiterbildung sieht vor, dass ein erster Bereich, der die Kontaktelemente umgibt, durch einen ersten Polyurethan-Schaum ausgefüllt ist, und ein zweiter Bereich, der den ersten Bereich umgibt, durch einen zweiten Polyurethan-Schaum ausgefüllt ist. Das Elastizitätsmodul des ersten Polyurethan-Schaums ist geringerer als das Elastizitätsmodul des zweiten Polyurethan-Schaums. Das Elastizitätsmodul des ersten Polyurethan-Schaums ist der Art gewählt, dass sich das Kontaktelement bei einer seitlich wirkenden Andruckkraft in dem Polyurethan-Schaum seitlich verschieben kann. Der weniger nachgiebige zweite Polyurethan-Schaum verhindert ein seitliches Verschieben des Kontaktelementes über den ersten Bereich hinaus. Das Elastizitätsmodul des zweiten Polyurethan-Schaums ist so groß, dass bei der typischen seitlich wirkenden Andruckkraft beim Aufsetzen eines Solarzellenmoduls auf das Kontaktelement der zweite Polyurethan-Schaum nicht verformt wird.

Die vorliegende Erfindung wird nachfolgend anhand bevorzugter Ausführungsformen und einer Zeichnung beispielhaft erläutert. In der Zeichnung zeigt:
- Fig. 1: eine erste Ausführungsform eines elektrischen Verbindungselements im Querschnitt;
- Fig. 2: eine Detailansicht eines Kontaktelementes aus der Figur 1;
- Fig. 3: eine zweite Ausführungsform eines elektrischen Verbindungselements in einer perspektivischen Ansicht; und
- Fig. 4: eine dritte Ausführungsform eines elektrischen Verbindungselements in einer Draufsicht.

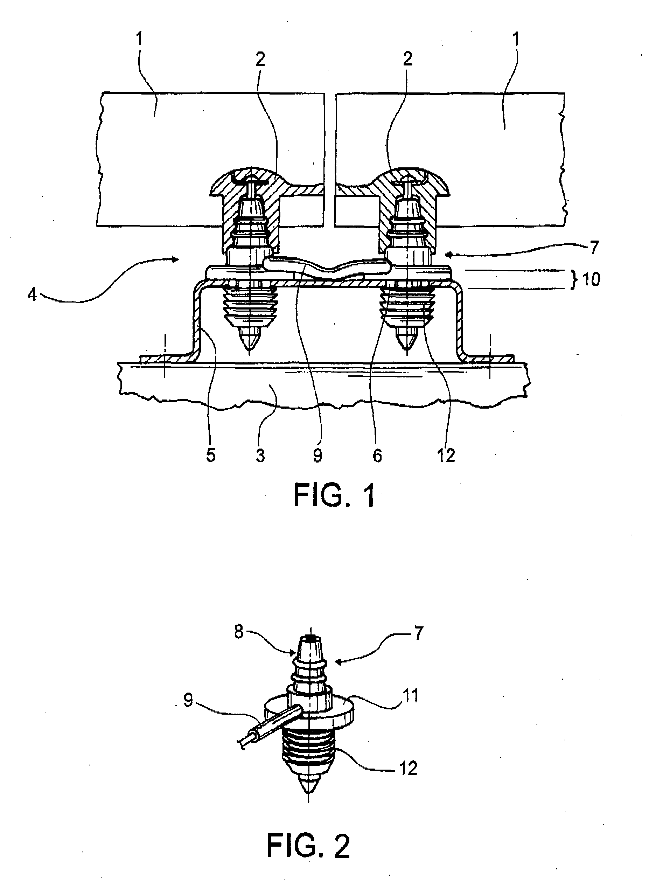

In Fig. 1 sind zwei Solarzellenmodule oder Solarzellengeneratoren zur elektrischen Energiegewinnung im Querschnitt schematisch dargestellt. Die Solarzellenmodule 1 weisen typischerweise mehrere Solarzellen auf, die aus Halbleitermaterialien oder anderen Materialien zur Umwandlung von Sonneneinstrahlung in elektrischer Energie geeignet sind. Die Solarzellen können als monokristalline, polykristalline oder Dünnschicht-Solarzellen ausgebildet sein. Zweckmäßigerweise werden die Solarzellen durch eine Glasschicht oder eine andere transparente Schicht mechanisch vor Umwelteinflüssen geschützt. Ein stabilisierender Rahmen und eine stabilisierende Rückwand gibt dem Solarzellenmodul 1 die notwendige mechanische Stabilität. Der Rahmen und die Rückwand können aus Metall, z. B. Aluminium, oder Kunststoff, z. B. Polyurethan, hergestellt sein.

Das Solarzellenmodul 1 weist intern eine Umverdrahtung auf, die die einzelnen Solarzellen elektrisch miteinander verbindet. Nach außen hin sind die Solarzellenmodule 1 über externe Anschlüsse 2 elektrisch kontaktierbar. Zweckmäßigerweise sind die externen Anschlüsse 2 im Rahmenbereich oder im Bereich der Ecken der Solarzellenmodule 1 angeordnet. Im in Fig. 1 gezeigten Beispiel sind die externen Anschlüsse 2 als Buchsen ausgebildet.

Die Solarzellenmodule 1 weisen typischerweise handhabbare Größen im Bereich zwischen 1 und 5 m² auf. Diese einzelnen Solarzellenmodule 1 werden z. B. auf einem Dach 3 oder anderen Flächen befestigt und nebeneinander angeordnet. Eine elektrische Umverdrahtung und Verbindung der externen Anschlüsse 2 der Solarzellenmodule 1 untereinander kann durch die Ausführungsform des elektrischen Verbindungselements 4 erfolgen.

Das elektrische Verbindungselement 4 weist ein Trägerelement 5 auf. Das Trägerelement 5 kann auf dem Dach 3 mittels geeigneter Befestigungsmittel, z. B. Schrauben, Nägeln oder Nieten befestigt werden. Das Trägerelement 5 kann auch an anderen Flächen oder vorgesehenen Stützelementen befestigt werden. In dem Trägerelement 5 sind Bohrungen 6 vorgesehen. Diese Bohrungen 6 bilden durchgehende Öffnungen oder Löcher in dem Trägerelement 5.

In den durchgehenden Löchern 6 sind Kontaktelemente 7, beispielhaft Stecker 7, gehaltert. Ein solcher Stecker 7 ist auch in Fig. 2 in einer perspektivischen Ansicht dargestellt. Der Stecker 7 weist in einem oberen Bereich einen elektrischen Kontaktbereich 8 auf. Dieser elektrische Kontaktbereich 8 ist als Gegenstück zu den Buchsen 2 der Solarzellenmodule 1 ausgebildet. Eine elektrische Verbindung, z. B. ein Kabel 9, oder eine sonstige Umverdrahtung wird aus dem Stecker 7 herausgeführt und das Kabel 9 ist mit dem elektrischen Kontaktbereich 8 elektrisch verbunden.

Der Stecker 7 weist einen Bereich 10 mit einer Einschnürung auf. Der Querschnitt des Steckers 7 ist in diesem Bereich gegenüber den benachbarten Bereichen verringert. Oberhalb der Einschnürung kann z. B. wie in Fig. 2 dargestellt der Stecker einen breiteren Ring 11 aufweisen. Unterhalb der Einschnürung 10 sind Widerhakenelemente 12 an dem Stecker 7 vorgesehen. Die Widerhakenelemente 12 sind derart orientiert, dass ein Einsetzen des Steckers 7 durch das Loch 6 möglich ist, ein Herausziehen des Steckers 7 nach einem Einsetzen verhindert wird.

Der Querschnitt oder Durchmesser des Steckers 7 im Bereich der Einschnürung 10 ist geringer als der Querschnitt oder der Durchmesser des Lochs 6. Der Stecker 7 weist somit ein seitliches Spiel auf. Entsprechend dem Spalt, der sich zwischen der Einschnürung und dem Trägerelement 5 ergibt, kann der Stecker 7 seitlich bewegt werden. Der Ring 11 und die Widerhaken 12 stabilisieren die Lage des Steckers in eine zur seitlichen Bewegungsrichtung senkrechte Richtung.

Das elektrische Verbindungselement 4 weist zweckmäßigerweise ein Paar von Steckern 7 auf. In anderen Ausführungsformen können auch mehrere Paare vorgesehen sein. Die beiden Stecker 7 eines Paares können einen unterschiedlichen Abstand zueinander bedingt durch die Halterung, d. h. in der Ausführungsform der Fig. 1 durch das Loch einnehmen.

Die Stecker 7 eines Paares sind durch ein flexibles Kabel 9 oder eine andere elektrische Verbindung miteinander elektrisch verbunden. Das flexible Kabel 9 kann eine Länge aufweisen, die entsprechend dem größtmöglichen Abstand der beiden Stecker 7 zueinander gewählt ist. In einer anderen Ausgestaltung ist das Kabel oder die elektrische Verdrahtung 9 mit einem elastischen Element versehen. Die elektrische Verdrahtung 9 kann folglich zusammengestaucht bzw. gedehnt werden.

Das elektrische Verbindungselement 4 kann in einem Gehäuse integriert werden. Ferner ist es möglich, das Gehäuse mit einem Polyurethan-Schaum zumindest teilweise auszufüllen.

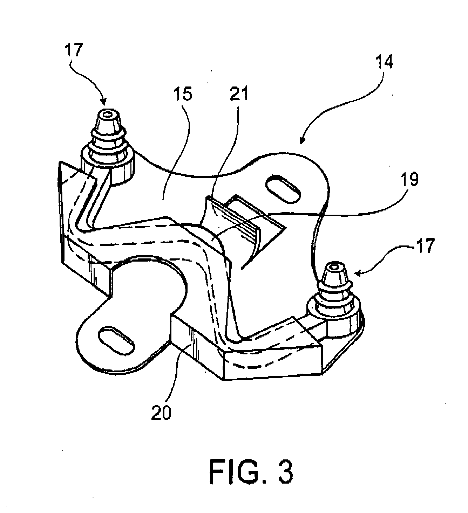

Eine andere Ausführungsform eines elektrischen Verbindungselementes 14 ist in Fig. 3 in perspektivischer Ansicht dargestellt. Das elektrische Verbindungselement 14 weist zwei Kontaktelemente 17, beispielsweise ausgebildet als Stecker, auf. Die beiden Stecker 17 können gleich dem Stecker 7 aus dem ersten Ausführungsbeispiel gebildet und durch ein Loch in einem Trägerelement 15 angeordnet sein.

In der in Fig. 3 dargestellten Ausführungsform bestehen die Stecker 17 aus einem oberen Kontaktbereich. Der Stecker 17 befindet sich somit oberhalb dem Trägerelement 15 oder der Trägerplatte und ist nicht durch einen Eingriff durch ein Loch mechanisch an der Trägerplatte 15 stabilisiert. Die Halterung der beiden Stecker 17 erfolgt durch die die beiden Stecker 17 verbindende elektrische Verbindung 19. Die elektrische Verbindung 19 ist mit einer Federkraft versehen, die ein seitliches Verschieben der Steckerelemente bei einem Einwirken einer seitlichen Kraft ermöglicht. Bei Abwesenheit einer seitlichen Kraft führt das Federelement der elektrischen Verbindung 19 die Stecker 17 wieder in ihre Ausgangsposition oder Ruheposition zurück. Die elektrische Verbindung 19 selbst ist mit dem Trägerelement 15 zumindest an zwei Punkten fest verbunden. Gleich in Fig. 3 kann dies durch zwei das Federelement teilweise umschließende Laschen 20, 21 bewerkstelligt werden.

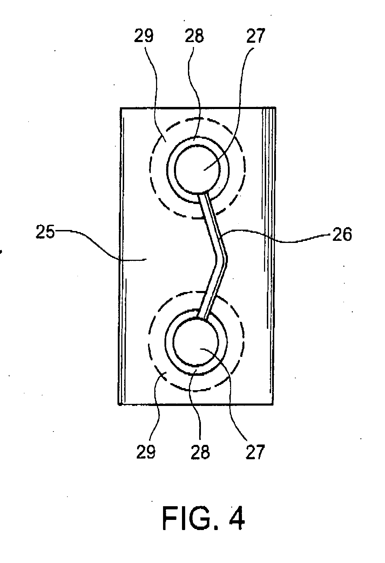

Eine weitere Ausführungsform ist in Fig. 4 schematisch in einer Draufsicht dargestellt. Auf einem Trägerelement 25 sind zwei Stecker 27 angeordnet. Die Stecker 27 sind von einem weichen Polyurethan-Schaum oder einem sonstig elastisch nachgiebigen Material 28 umschlossen. Das Material kann z. B. auch ein Schaumband sein. Das weiche nachgiebige Material 28 ist von einem härteren wenig nachgiebigen Material 29 umschlossen. Der Stecker 27 kann somit innerhalb des weichen Materials 28 verschoben werden. Ein Herausfallen des Steckers 27 oder ein zuweitgehendes Verschieben des Steckers 27 wird durch das härtere Material 29 verhindert. Die Stecker 27 werden durch die beiden Polyurethan-Schäume 28. 29 gehaltert.

Die beiden Stecker 27 sind durch eine Kabelverbindung 26 miteinander verbunden. Die Kabelverbindung kann wie in einer der vorhergehenden Ausführungsformen sein.

Obwohl die Erfindung vorhergehend anhand bevorzugter Ausführungsformen beschrieben wurde, ist sie nicht darauf beschränkt.

Insbesondere kann statt der Verwendung eines Steckers auch eine Buchse des Kontaktelements auf dem elektrischen Verbindungselement angeordnet sein.

### Bezugszeichenliste

- 1: Solarzellenmodul
- 2: externer Anschluss
- 3: Dach
- 4, 14: elektrisches Verbindungselement
- 5, 15, 25: Trägerelement
- 6: Löcher
- 7, 17, 27: Kontaktelemente
- 8: Kontaktbereich
- 9, 19, 26: elektrische Verbindung
- 10: Einschnürung
- 11: Ring
- 12: Widerhakenelemente
- 28: weicher Polyurethan-Schaum
- 29: harter Polyurethan-Schaum

## Patentansprüche

1. Elektrisches Verbindungselement, insbesondere zum elektrischen Verbinden zweier Solarmodule (1), mit:
einer Trägereinrichtung (5; 15; 25),
mindestens einer Halterung (6; 19; 28, 29), die an der Trägereinrichtung angeordnet ist, und
mindestens einem Kontaktelement (7; 17; 27), das durch eine der Halterungen (6; 19; 28, 29) beweglich zu der Trägereinrichtung (5; 15; 25) angeordnet ist.

2. Elektrisches Verbindungselement nach Anspruch 1,
**dadurch gekennzeichnet,**
**dass** eine flexible elektrische Verbindung (9; 19; 26) ein erstes der Kontaktelemente mit einem zweiten der Kontaktelemente verbindet.

3. Elektrisches Verbindungselement nach Anspruch 1,
**dadurch gekennzeichnet,**
**dass** die flexible elektrische Verbindung (9; 19; 26) durch ein elektrisch leitendes Federelement gebildet ist.

4. Elektrisches Verbindungselement nach einem der vorhergehenden Ansprüche,
**dadurch gekennzeichnet,**
**dass** die Halterung (19; 28, 29) mindestens ein Federelement (19; 28) zum Rückstellen einer der mindestens einen Halterung (19; 28, 29) aufweist.

5. Elektrisches Verbindungselement nach einem der vorhergehenden Ansprüche,
**dadurch gekennzeichnet,**
**dass** die mindestens eine Halterung (6) als durchgehendes Loch in der Trägereinrichtung (5, 15) ausgebildet ist und das mindestens eine Kontaktelement (7, 17) in das durchgehende Loch (6) eingesteckt ist.

6. Elektrisches Verbindungselement nach Anspruch 5,
**dadurch gekennzeichnet,**
**dass** in der Ebene des durchgehenden Lochs (6) in zumindest einer Richtung das Kontaktelement (7; 17) von der Trägereinrichtung (5; 15) durch einen Spalt beabstandet ist.

7. Elektrisches Verbindungselement nach Anspruch 5 oder 6,
**dadurch gekennzeichnet,**
**dass** ein Bereich des mindestens einen Kontaktelements (7; 17), der innerhalb des durchgehenden Lochs (6) angeordnet ist, einen durch eine Einschnürung (10) verringerten Querschnitt gegenüber benachbarten Bereichen des Kontaktelementes (7; 17) aufweist.

8. Elektrisches Verbindungselement nach einem der vorhergehenden Ansprüche,
**dadurch gekennzeichnet,**
**dass** das mindestens eine Kontaktelement (7; 17; 27) in einen Schaumstoff, in einen Kunststoff und/oder in Polyurethan-Schaum eingebettet ist.

9. Elektrisches Verbindungselement nach Anspruch 6,
**dadurch gekennzeichnet,**
**dass** der Spalt durch einen Schaumstoff, einen Kunststoff und/oder Polyurethan-Schaum ausgefüllt ist.

10. Elektrisches Verbindungselement nach einem der vorhergehenden Ansprüche,
**dadurch gekennzeichnet,**
**dass** ein erster Bereich, der die Kontaktelemente umgibt, durch einen ersten Kunststoff (28) ausgefüllt ist, und ein zweiter Bereich, der den ersten Bereich umgibt, durch einen zweiten Kunststoff (29) ausgefüllt ist, wobei das Elastizitätmodul des ersten Kunststoffs (28) geringerer als der Elastizitätsmodus des zweiten (29) ist.

11. Elektrisches Verbindungselement nach einem der vorhergehenden Ansprüche,
**dadurch gekennzeichnet**,
der erste Kunststoff einen Schaumstoff oder einen Polyurethan-Schaum aufweist.
